# FASCICULE DE BREVET EUROPEEN

(11) **EP 2 031 714 B1**
(45) Date de publication et mention de la délivrance du brevet: **18.08.2010**
(21) Numéro de dépôt: 07115378.7
(22) Date de dépôt: 31.08.2007
(51) Int. Cl.: H01S 5/02, H01L 25/16, H01S 5/183, G06F 3/03

(54) **Circuit optoélectronique ayant un photorécepteur et une diode laser, et module le comprenant**
Optoelektronischer Schaltkreis mit einem Photoempfänger und einer Laserdiode und diesen umfassendes Modul
Optoelectronic circuit with a photoreceiver and a laser diode, and a module comprising the same

(43) Date de publication de la demande: 04.03.2009
(73) Titulaire: EM Microelectronic-Marin SA, 2074 Marin (CH)
(72) Inventeur: Willemin, Michel, 2515 Prêles (CH); Grandjean, André, 2088 Cressier (CH); Quercia, Victorio, 1586 Vallamond (CH); Kayal, Abdul-Hamid, 2000 Neuchâtel (CH); Tanner, Steve, 1435 Essert-Pittet (CH)
(74) Mandataire: Couillard, Yann Luc Raymond

(56) Documents cités:
- EP-A- 1 324 396
- FR-A- 2 849 215
- GB-A- 2 300 301
- US-A- 5 978 401
- US-A1- 2002 071 459
- US-B1- 6 567 435

## Description

L'invention concerne un circuit optoélectronique qui comprend au moins un photorécepteur et une diode laser. Le photorécepteur est réalisé dans un premier matériau semi-conducteur, et comprend au moins une région photosensible à matrice de pixels pour capter de la lumière. La diode laser est par contre réalisée dans un second matériau semi-conducteur, qui est différent du premier matériau semi-conducteur.

L'invention concerne également un module optoélectronique comprenant le circuit optoélectronique.

Un circuit optoélectronique, monté sur une plaque ou support à circuit imprimé pour former un module optoélectronique, peut être utilisé dans un petit instrument, tel qu'une souris d'ordinateur optique sans fil ou un dispositif de pointage ou tout autre petit instrument. Pour une application dans une souris optique RF sans fil traditionnelle, la source de lumière utilisée peut être une diode électroluminescente LED. Cette diode électroluminescente doit être placée sur la plaque à circuit imprimé à une certaine distance du photorécepteur pour pouvoir émettre un faisceau de lumière avec un certain angle par rapport à la surface de travail sur laquelle est posée la souris optique. Le faisceau de lumière de la diode électroluminescente doit donc être suffisamment rasant pour pouvoir jouer avec la granularité de la surface de travail et réfléchir une partie de la lumière en direction du photorécepteur pour détecter un mouvement de la souris.

Comme la diode électroluminescente doit être montée à un endroit de la plaque à circuit imprimé suffisamment distant de l'endroit du photorécepteur et de sa région photosensible par exemple à une distance de l'ordre de 10 mm, le module optoélectronique les comprenant ne peut pas être miniaturisé au-delà d'une certaine limite. De plus, un bloc transparent à au moins une lentille doit être prévu sur la diode pour l'émission de lumière et sur le photorécepteur pour la réception de lumière. Ceci rend donc le module optoélectronique relativement volumineux. Si une telle diode et le photorécepteur sont montés sur une plaque à circuit imprimé flexible, il est nécessaire encore de rigidifier certaines parties pour éviter tout décalage entre le faisceau de lumière émis par la diode et la partie de réception du photorécepteur.

Il est à noter également qu'avec un faisceau de lumière relativement rasant généré par la diode électroluminescente, une grande partie de la lumière produite par la diode électroluminescente est perdue. De ce fait, beaucoup d'énergie électrique et lumineuse est également gaspillée avec un bruit important. De plus avec un module optoélectronique traditionnel pour une souris optique sans fil, il y a une grande sensibilité au type de surfaces sur lequel la souris optique est posée, ce qui constitue un inconvénient. Il est préférable de pouvoir travailler ainsi sur une surface dite surface lambertienne pour une bonne réflexion de la lumière. Même avec toutes les améliorations susceptibles d'être apportées, la consommation en énergie électrique reste relativement importante, ce qui peut nuire à la durée de vie des deux cellules de batterie de fonctionnement d'une telle souris.

Pour éviter les problèmes rencontrés avec l'utilisation d'une diode électroluminescente, il peut être imaginé l'emploi d'une diode laser comme pour la présente invention. Avec une diode laser, il est possible de profiter de la cohérence du faisceau laser émis et réfléchi sur la surface de travail. Le faisceau n'a plus l'obligation d'être incliné fortement notamment pour la détection du mouvement de la souris optique. En fonction du chemin du faisceau laser jusqu'à la réflexion sur la surface de travail, il peut y avoir une interférence constructive ou destructive entre le faisceau laser émis et réfléchi. Ceci permet de détecter le mouvement de la souris optique étant donné que la granularité de la surface de travail, pour définir des speckles en terminologie anglaise, peut avoir une profondeur plus grande que la moitié de la longueur d'onde du faisceau laser émis.

A ce titre, la diode laser et le photorécepteur du circuit optoélectronique peuvent être montés sur un support à circuit imprimé et encapsulés dans un unique boîtier du module optoélectronique compact comme montré dans la demande de brevet WO 2006/042072. Généralement une ouverture est prévue dans le module pour l'émission de lumière vers l'extérieur et une ouverture pour la réception de la lumière réfléchie notamment sur une surface. Un bloc de lentilles pour diriger la lumière émise et reçue est fixé sur les ouvertures du module. Ce bloc transparent bouche les ouvertures afin également de protéger la diode laser et le photorécepteur de la poussière et des conditions de l'environnement.

Même avec l'agencement de la diode laser et du photorécepteur du circuit optoélectronique dans un unique boîtier d'un module compact traditionnel, les dimensions du module avec le circuit optoélectronique ne peuvent être suffisamment réduites. Ceci constitue un inconvénient des différents modules avec circuit optoélectronique connus. De plus, les coûts de production de tels circuits optoélectroniques et des modules optoélectroniques obtenus ne peuvent être grandement réduits.

Il est également connu par les brevets GB 2 300 301 et FR 2 849 215 de réaliser un circuit optoélectronique, qui comprend une diode laser réalisée sur un substrat photorécepteur. La diode laser par exemple du type VCSEL en arséniure de gallium est réalisée directement sur le substrat photorécepteur en arséniure de gallium.

L'invention a donc pour but de fournir un circuit optoélectronique ayant au moins un photorécepteur et une diode laser susceptible de pallier aux inconvénients de l'état de la technique susmentionnés et permettant de réduire la taille dudit circuit et les coûts de production.

A cet effet, l'invention selon la revendication 1 concerne un circuit optoélectronique cité ci-devant qui se **caractérise en ce que** la diode laser est montée et électriquement connectée directement sur une partie du photorécepteur.

Un avantage du circuit optoélectronique réside dans le fait qu'avec la combinaison de la diode laser sur le photorécepteur, un unique composant compact est réalisé. La diode laser est aussi bien fixée sur une partie du photorécepteur qu'électriquement reliée à des pistes ou plages conductrices du photorécepteur. Ainsi, il est possible de réduire les coûts de fabrication du circuit optoélectronique et d'un module obtenu le comprenant. Il est également possible de pouvoir livrer chaque circuit optoélectronique, qui comprend le photorécepteur et la diode laser, soit sur plaquette avant l'opération de sciage, soit par unité après l'opération de sciage de la plaquette. Le circuit optoélectronique réalisé offre ainsi des performances supérieures en terme de précision et robustesse de détection de mouvement sur tout type de surface de travail.

La diode laser utilisée est avantageusement une diode laser VCSEL de préférence monomode. Ce type de diode laser envoie un faisceau laser étroit sous forme conique dans une direction sensiblement verticale par rapport à l'agencement des couches semi-conductrices la constituant, et par rapport à la surface du photorécepteur recevant la diode laser. Le matériau semi-conducteur d'une telle diode VCSEL est par exemple de l'arséniure de gallium (GaAs), alors que le matériau semi-conducteur du photorécepteur est de préférence du silicium.

Grâce à l'utilisation d'une diode laser VCSEL monomode sur le photorécepteur, il est possible d'obtenir des performances améliorées et plus robustes du circuit optoélectronique par rapport à un circuit de l'état de la technique. L'efficacité de cette diode laser pour la génération de lumière est plus haute qu'une diode électroluminescente classique. Il en est de même pour son efficacité de puissance.

Pour une utilisation dans une souris optique sans fil par exemple, le circuit optoélectronique de la présente invention permet une détection du mouvement ou de toute action sur n'importe quel type de surfaces de par la nature cohérente de la lumière émise par la diode VCSEL. Avec une telle diode laser, le faisceau laser est émis sensiblement perpendiculairement à une surface de travail, ce qui permet de travailler même sur des surfaces non lambertiennes. De plus, grâce à l'efficacité de la diode laser, il est possible d'avoir une autonomie de la batterie plus longue. Une seule cellule de batterie d'une durée de vie d'au moins une année peut être utilisée. Ceci permet de réduire également l'espace à disposition par exemple dans une souris optique, et les coûts. La consommation en énergie électrique est fortement réduite avec cette diode laser par exemple en l'alimentant selon un petit rapport cyclique tout en lui permettant une illumination réduite par un chemin optique plus court qu'avec une diode électroluminescente traditionnelle.

Comme la diode laser VCSEL est de dimension bien inférieure à celle du photorécepteur, cette diode peut avantageusement être montée dans une cavité réalisée à travers la couche de passivation du photorécepteur. Cette cavité est de préférence de longueur et largeur équivalentes à celles de la diode laser, ce qui permet da faciliter son positionnement lors de son montage sur le photorécepteur. De plus, la cavité de réception de la diode laser donne accès directement à une plage métallique de contact du photorécepteur pour la connexion électrique d'une borne de la diode laser. Ceci est prévu sans étapes supplémentaires dans le procédé de réalisation du photorécepteur.

Pour ce faire, une première plage conductrice au dos de la diode laser peut être fixée à la plage correspondante métallique de contact dans la cavité du photorécepteur. Une seconde plage conductrice ou électrode sur le dessus de la diode laser peut être reliée par un fil métallique à une autre plage métallique de contact du photorécepteur accessible depuis l'extérieur. Le fil métallique de liaison de la diode est de préférence un fil d'or pour des questions de fragilité du matériau de la diode VCSEL. L'épaisseur totale du circuit optoélectronique combinant le photorécepteur et la diode laser est ainsi relativement faible.

La cavité de réception de la diode laser sur le photorécepteur peut être réalisée avantageusement au centre de la matrice de pixels de la région photosensible du photorécepteur. Ceci permet de réaliser un partage de l'optique d'un unique bloc de lentilles, qui peut être monté sur au moins une région photosensible du photorécepteur pour la conception d'un module optoélectronique compact. Bien entendu, cette cavité peut être disposée dans une région à unité de commande et de traitement du photorécepteur adjacent à la région photosensible, mais pas dans une zone de piquage du circuit optoélectronique terminé.

Selon un exemple utile à la compréhension de l'invention, la diode laser VCSEL peut également être connectée à l'aide de deux plages métalliques de contact au dos de la diode sur deux bosses métalliques correspondantes ou plusieurs bosses réalisées sur des plages de contact du photorécepteur. Ce type de montage est effectué par une technique dénommée "flip chip" en terminologie anglaise. Cependant avec ce type de connexion, il est plus difficile de garantir un aussi bon positionnement et orientation de la diode laser sur le photorécepteur qu'avec une cavité de réception réalisée dans la couche de passivation. La diode laser fixée sur le photorécepteur doit en principe ne pas être inclinée.

L'invention a encore pour but de fournir un module optoélectronique comprenant le circuit optoélectronique et susceptible de pallier aux inconvénients de l'état de la technique susmentionnés pour permettre de réduire la taille du module obtenu et les coûts de production.

A cet effet, l'invention concerne encore un module optoélectronique cité ci-devant qui comprend les caractéristiques définies dans la revendication 15.

Un avantage du module optoélectronique réside dans le fait qu'il peut n'utiliser qu'un seul bloc de lentilles aussi bien pour la diode laser qu'au moins une matrice de pixels de la région photosensible du photorécepteur. Ceci permet un partage de l'optique aussi bien pour l'émission du faisceau laser vers l'extérieur du module que pour la réception de la lumière réfléchie sur une surface de travail et provenant du faisceau laser.

Les buts, avantages et caractéristiques du circuit optoélectronique et du module optoélectronique le comprenant apparaîtront mieux dans la description suivante de formes d'exécution non limitatives illustrées par les dessins sur lesquels :
les figures 1a et 1b représentent une vue en coupe verticale partielle de deux manières de connecter la diode laser sur le photorécepteur du circuit optoélectronique, d'une part dans une cavité du photorécepteur, et d'autre part par la technique dite flip chip en terminologie anglaise; la figure 1a représente un circuit optoélectronique selon l'invention; la figure 1b représente un exemple utile à la compréhension de l'invention;
la figure 2 représente une vue de dessus d'une première forme d'exécution du circuit optoélectronique selon l'invention,
la figure 3 représente une vue de dessus d'une seconde forme d'exécution du circuit optoélectronique selon l'invention,
la figure 4 représente une vue de dessus partielle de la seconde forme d'exécution représentée à la figure 3, avec une région photosensible du photorécepteur composée de deux matrices de pixels agencées l'une au centre de l'autre,
la figure 5 représente une vue en coupe partielle verticale d'un premier module optoélectronique comprenant un circuit optoélectronique selon l'invention en partie selon la première forme d'exécution de la figure 2,
la figure 6 représente une vue de dessus d'une troisième forme d'exécution du circuit optoélectronique selon l'invention, et
la figure 7 représente une vue en coupe partielle verticale d'un second module optoélectronique comprenant un circuit optoélectronique selon l'invention de la troisième forme d'exécution de la figure 6.

Dans la description suivante, toutes les parties du circuit optoélectronique et du module le comprenant, qui sont bien connues d'un homme du métier dans ce domaine technique, ne sont relatées que de manière simplifiée.

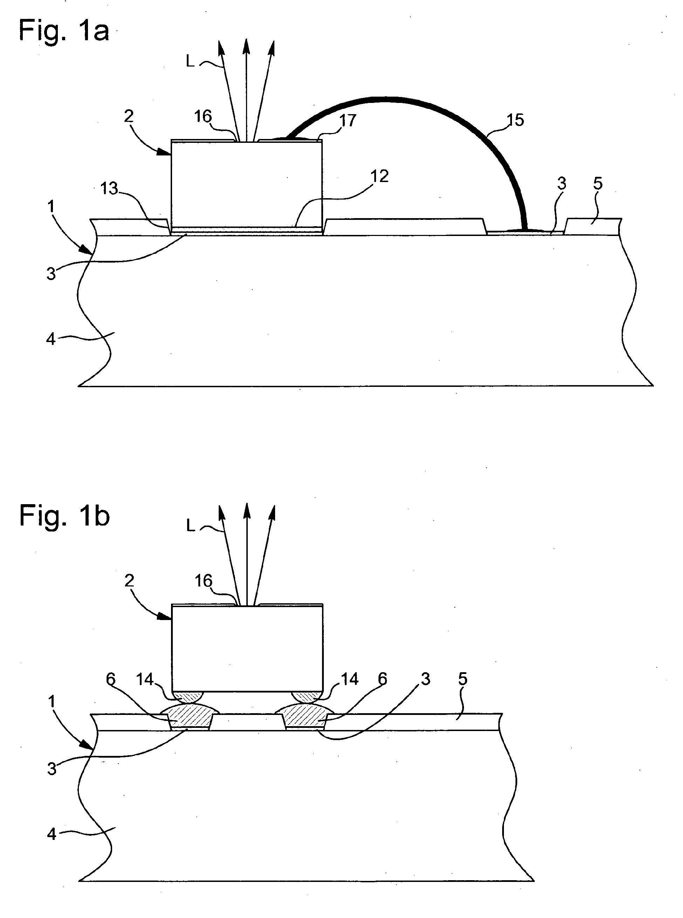

Aux figures 1a et 1b, le circuit optoélectronique comprend un photorécepteur 1 sur lequel est monté et électriquement connecté une diode laser 2. Le photorécepteur 1 est réalisé dans un premier matériau, qui est un substrat semi-conducteur en silicium 4, alors que la diode laser 2 est réalisée dans un second matériau, qui est de préférence un substrat semi-conducteur en arséniure de gallium (GaAs).

La diode laser 2 peut être une diode laser VCSEL (vertical cavity surface emitting laser en terminologie anglaise) monomode. Une telle diode laser 2 est réalisée de manière connue par une juxtaposition de couches dopées d'arséniure de gallium et de couches d'AlGa ou AlAs ou InGaAs. La génération de lumière est opérée dans une zone active au centre de la diode, et le faisceau laser généré sort à travers une ouverture 16 au centre d'une électrode 17 réalisée sur une surface supérieure. Le faisceau laser L sort sous la forme d'un cône étroit par l'ouverture 16 et de manière dite sensiblement verticale par rapport à l'agencement des couches semi-conductrices constituant ladite diode et à la surface du photorécepteur recevant la diode.

La diode laser VCSEL est un très petit élément qui est souvent difficile à manipuler. Ses dimensions en largeur et longueur peuvent être de l'ordre de 200 µm x 200 µm ou légèrement supérieures, et d'une épaisseur de l'ordre de 150 µm. De ce fait étant donné ses très petites dimensions, il peut être imaginé de monter et connecter électriquement une telle diode laser 2 sur une partie du photorécepteur 1 pour pouvoir constituer un circuit optoélectronique selon l'invention sous la forme d'un unique composant.

A la figure 1a, la diode laser 2 peut être montée dans une cavité 13 réalisée dans la couche de passivation 5 obtenue au terme du procédé de fabrication du photorécepteur 1. Cette couche de passivation 5 peut être d'épaisseur de l'ordre de 1 µm, ce qui n'est bien évidemment pas illustré de manière précise sur les dessins pour une meilleure clarté desdits dessins. De plus, plusieurs ouvertures sont réalisées dans la couche de passivation 5 pour donner normalement accès à des plages métalliques de contact 3 du photorécepteur. Ces plages de contact 3 sont habituellement reliées par fil métallique à des plages conductrices d'une plaque ou support à circuit imprimé sur lequel est monté le photorécepteur. La largeur de chaque plage de contact peut être de 100 µm, alors que l'espace entre chaque plage peut être par exemple de 200 µm.

La diode laser VCSEL 2 peut comprendre une plage conductrice ou métallique 12 au dos, qui peut couvrir par exemple toute la surface inférieure de ladite diode laser. Cette plage métallique 12 est reliée directement sur une plage métallique 3 du photorécepteur à travers l'ouverture de la cavité 13 réalisée dans la couche de passivation 5 pour définir par exemple une borne de masse de la diode. Cette plage métallique 3 au fond de la cavité peut être composée aussi de plusieurs portions métalliques légèrement espacées l'une de l'autre pour faciliter la fixation de la diode dans la cavité. La liaison électrique entre la plage métallique 12 et la plage métallique 3 du photorécepteur 1 peut être effectuée par ultrason, par une opération de soudure des deux plages l'une sur l'autre ou par l'intermédiaire d'une couche de colle conductrice non représentée.

L'ouverture de la cavité 13 est dimensionnée en fonction de la taille de ladite diode laser, c'est-à-dire légèrement supérieure à la largeur et longueur de ladite diode laser de manière à faciliter son montage dans la cavité et sa connexion électrique. De ce fait, la plage métallique 3 accessible du photorécepteur 1 pour recevoir la diode laser 2 doit être au moins légèrement supérieure à 200 µm x 200 µm, qui peut être la taille de ladite diode.

Une fois montée et électriquement connectée dans la cavité 13 de la couche de passivation 5 du photorécepteur 1, une électrode 17, qui est réalisée sur la surface supérieure de la diode laser 2, peut être reliée par fil métallique 15 à une autre plage de contact 3 prévue à cet effet du photorécepteur 1. Ce fil métallique est de préférence un fil en or étant donné la fragilité du matériau composant la diode laser VCSEL. Cette électrode 17 définit par exemple une borne de potentiel haut de la diode laser. De cette manière, une tension d'alimentation peut être appliquée entre l'électrode 17 et la borne de masse 12 de la diode pour la génération du faisceau laser L sortant par l'ouverture 16 à travers l'électrode 17. Cette tension d'alimentation est fournie par exemple par une unité de commande et de traitement de signaux du photorécepteur qui commande ainsi la diode laser.

A la figure 1b, la diode laser 2 peut être montée sur le photorécepteur 1 par une technique dite flip chip en terminologie anglaise. Pour ce faire, la diode laser 2 peut comprendre au moins deux plages ou bosses métalliques 14 au dos pour définir d'une part la borne de masse et d'autre part la borne de potentiel haut. Pour sa part, le photorécepteur 1 peut comprendre des bosses métalliques 6 réalisées sur des plages de contact 3. Les bosses métalliques 6 pour connecter la diode laser 2 peuvent être plus rapprochées que l'espace nécessaire entre deux plages traditionnelles de contact 3 du photorécepteur 1.

Les plages de contact 3 du photorécepteur 1 sont réalisées de manière traditionnelle sur le substrat semi-conducteur 4. Des ouvertures dans la couche de passivation finale 5 déposée sur le substrat 4 sont tout d'abord prévues pour donner accès à chaque plage de contact 3. Les bosses métalliques 6 sont réalisées par la suite à travers les ouvertures de la couche de passivation 5 depuis chaque plage de contact 3 pour dépasser de la surface supérieure de ladite couche de passivation. Les bosses métalliques 14 de la diode laser 2 sont positionnées ensuite au-dessus de deux bosses métalliques 6 du photorécepteur prévues pour recevoir ladite diode. La fixation de la diode laser 2 sur le photorécepteur 1 par l'intermédiaire des bosses métalliques 6, 14 en contact peut être obtenu par exemple par thermocompression ou par ultrason.

Bien entendu, la diode laser 2, qui peut comprendre deux ou quatre bosses métalliques 14 au dos pour son maintien stable et sa connexion électrique au photorécepteur, peut être également positionnée dans une cavité réalisée à cet effet dans la couche de passivation 5 comme indiqué en référence à la figure 1a. Dans ce cas, il doit être prévu au moins deux plages de contact 3 séparées accessibles au fond de la cavité 13. Ceci permet d'éviter de devoir relier par un fil métallique une borne de la diode à une autre plage de contact 3 du photorécepteur. De plus, la diode laser VCSEL 2, dans la cavité de la couche de passivation 5 dimensionnée pour la recevoir, est en partie protégée lors de la manipulation du circuit optoélectronique obtenu. L'épaisseur du circuit optoélectronique dans ce cas de figure est suffisamment réduite.

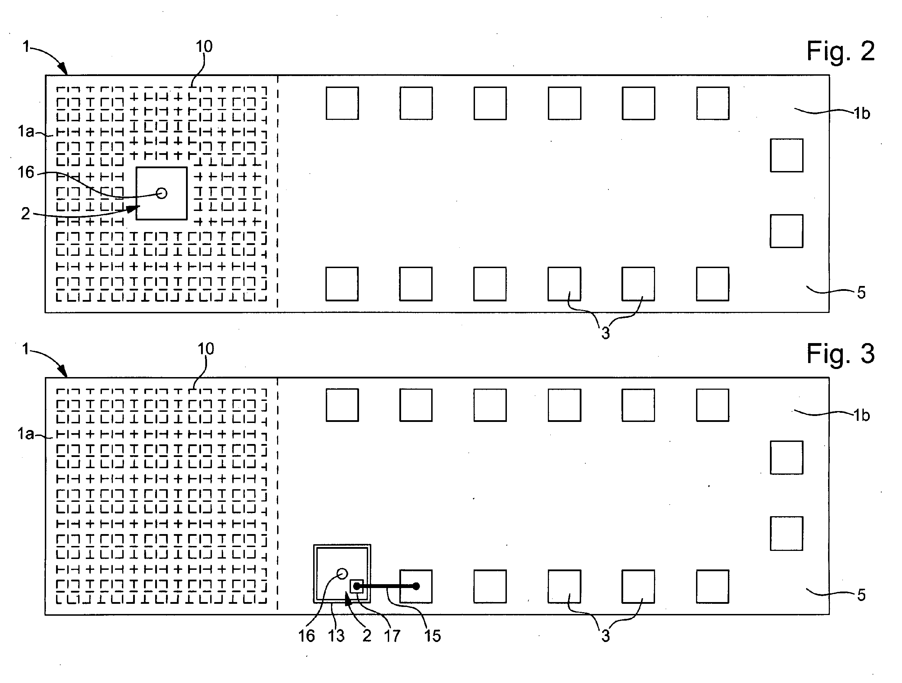

Une première forme d'exécution du circuit optoélectronique est représentée à la figure 2. Sur cette figure 2, la diode laser VCSEL 2 est montrée en vue de dessus connectée au photorécepteur 1 selon la seconde manière expliquée en référence à la figure 1b par la technique dite flip chip. La diode laser 2 est préférentiellement placée au centre d'une matrice de pixels 10 d'une région photosensible 1a du photorécepteur. L'ouverture 16 du passage de lumière de la diode est placée au centre de l'électrode réalisée sur la surface supérieure de la diode laser 2.

Deux pistes métalliques non représentées sur le photorécepteur 1 relient les deux bosses métalliques du photorécepteur à la région à unité de commande et de traitement 1 b. Les deux bosses métalliques au dos de la diode laser 2 sont fixées sur les deux bosses correspondantes réalisées au centre de la matrice de pixel. Ceci permet de pouvoir n'utiliser qu'un seul bloc optique de lentilles pour un partage de l'optique lors du montage du circuit optoélectronique dans un module.

Le photorécepteur 1 dans cette première forme d'exécution comprend donc une région photosensible 1a et une région 1 b adjacente, qui comprend une unité de commande et de traitement des signaux pour traiter les signaux électriques fournis par les pixels de la région photosensible. Chaque pixel de la matrice, représentée schématiquement sous forme carrée, fournit un signal à l'unité de traitement en fonction de la lumière captée qui provient d'une réflexion du faisceau laser, généré par la diode laser, sur une surface de travail. Cette matrice peut comporter de 15 x 15 pixels à 30 x 30 pixels pour une largeur de chaque pixel comprise entre 10 et 40 µm. Cependant étant donné l'emplacement de la diode laser au centre de cette matrice une portion de pixels de la matrice n'est pas réalisée. La surface totale du photorécepteur avec les deux régions 1a et 1 b peut être de dimension inférieure à 3 mm² par exemple de l'ordre de 2 mm².

Dans cette première forme d'exécution, toutes les plages de contact 3 du photorécepteur sont disposées uniquement dans la région à unité de commande et de traitement 1 b en laissant libre la région photosensible 1a. La région photosensible 1a est juxtaposée à un côté de la région à unité de commande et de traitement pour définir deux régions distinctes dans un même substrat semi-conducteur, tel qu'en silicium. Bien entendu dans le cas où la diode laser 2 est reliée au photorécepteur 1 au moyen de la technique dite flip chip, des bosses métalliques non représentées peuvent être réalisées sur les plages de contact 3 du photorécepteur. Ces bosses métalliques dépassent légèrement de la surface supérieure de la couche de passivation 5.

Les plages de contact 3 sont réparties de préférence de manière symétrique dans la région à unité de commande et de traitement 1b. Ces plages de contact sont disposées par exemple selon deux rangées en périphérie dans le sens de la longueur des deux régions juxtaposées. Un nombre égal de plages de contact à relier électriquement, qui sont régulièrement ou symétriquement espacées l'une de l'autre, peut être prévu dans chaque rangée. Il peut encore être prévu deux plages de contact 3 ou plus sur un côté de la région à unité de commande et de traitement 1b opposé à la région photosensible 1a.

La répartition symétrique des plages de contact 3 avec les bosses métalliques peut être nécessaire pour assurer un assemblage fiable du circuit optoélectronique obtenu sur une plaque ou support à circuit imprimé par la technique flip chip. Ainsi lors de l'assemblage aucune force n'est appliquée du côté de la région photosensible, ce qui peut la protéger de toute contrainte mécanique.

Une seconde forme d'exécution du circuit optoélectronique est représentée à la figure 3. Sur cette figure 3, la diode laser VCSEL 2 est montrée en vue de dessus connectée au photorécepteur 1 selon la première manière expliquée en référence à la figure 1a. La diode laser VCSEL 2 est logée et connectée électriquement dans une cavité 13 réalisée dans la couche de passivation 5. Un fil métallique 15 relie la borne de potentiel haut constituée par l'électrode 17 de la diode à une autre plage adjacente de contact 3 du photorécepteur 1.

De préférence, la diode laser est positionnée dans la région 1b à unité de commande et de traitement à proximité de la région photosensible 1a pour pouvoir n'utiliser qu'un seul bloc optique de lentilles lors du montage dans un module. De plus, son emplacement doit être suffisamment éloigné de l'endroit de piquage du circuit optoélectronique.

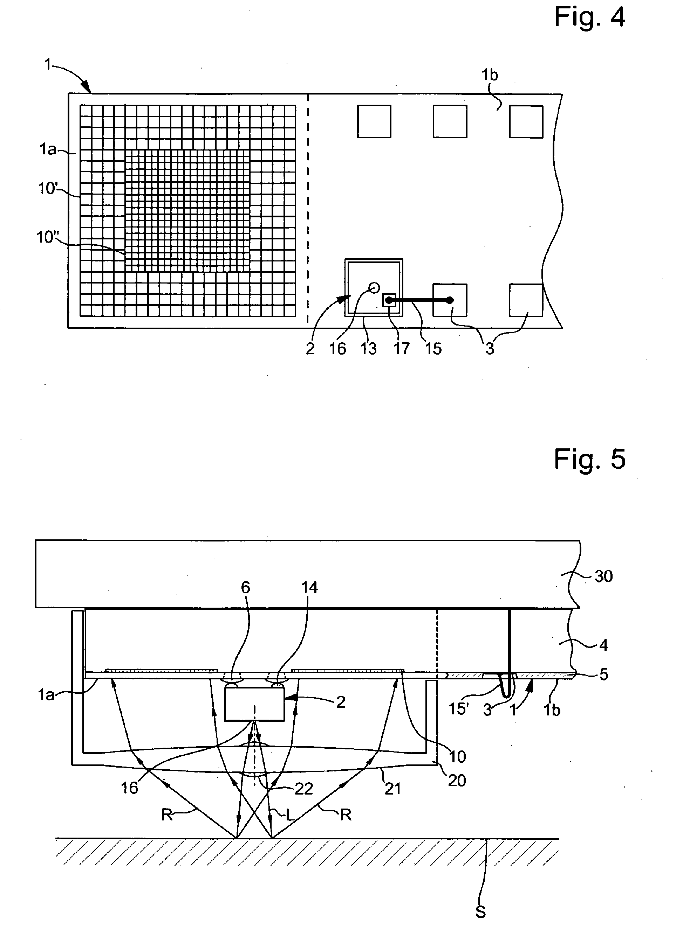

A la figure 4, il est représenté spécifiquement la région photosensible 1a du photorécepteur 1 et la connexion de la diode laser selon la première manière décrite en référence à la figure 1a.

Cette région photosensible 1a comprend deux matrices de pixels 10' et 10", qui sont agencées l'une au centre de l'autre. La première matrice de pixels 10" disposée au centre est composée de pixels plus fins, alors que la seconde matrice de pixels 10' entourant la première matrice de pixels est composée de plus gros pixels. De par cette structure à l'image de l'oeil humain, les pixels de la première matrice 10" sont utilisés pour la détection cohérente de la granularité de surface, car ils sont plus précis, mais incapables de détecter des mouvements de grande amplitude. Les pixels de la seconde matrice 10' sont quant à eux utilisés pour la détection de mouvement de bord, car ils sont plus rapides et compatibles avec des mouvements de grande amplitude, mais moins précis.

A la figure 5, un premier module optoélectronique comprenant un circuit optoélectronique selon l'invention est représenté partiellement. Ce module optoélectronique peut équiper par exemple un petit instrument, tel qu'une souris d'ordinateur optique sans fil. Le circuit optoélectronique utilisé pour la réalisation de ce premier module se base en partie selon la première forme d'exécution de la figure 2. La diode laser 2 est fixée par ses deux bosses métalliques 14 aux deux bosses métalliques correspondantes 6 du photorécepteur 1 au centre de la matrice de pixels 10 de la région photosensible 1a.

Le substrat 4 du photorécepteur 1 du circuit optoélectronique est monté sur une plaque ou support à circuit imprimé 30, qui peut être rigide ou flexible. La région à unité de commande et de traitement 1b comprend l'ensemble des plages de contact 3 susceptibles d'être reliées par exemple par un fil métallique en aluminium 15' à chaque plage conductrice correspondante du circuit imprimé. Un boîtier opaque ou une résine d'encapsulation non représentés peuvent être placés sur cette région 1b pour la protéger notamment de la lumière.

Bien entendu, il aurait pu être envisagé également de réaliser des bosses métalliques 6 non représentées sur les plages de contact de la région 1 b. Ceci permettrait de pouvoir connecter le circuit optoélectronique directement sur des plages conductrices correspondantes du circuit imprimé, qui sont agencées de manière équivalente aux bosses métalliques. Dans ce cas, il devrait être prévu une ouverture traversante non représentée dans la plaque ou support à circuit imprimé 30 au-dessus de la région photosensible 1a du circuit optoélectronique.

Le module optoélectronique comprend encore un unique bloc de lentilles 20, qui est monté sur la région photosensible 1a du circuit optoélectronique. Ce bloc de lentilles à partage de l'optique comprend, dans une position centrale, une première lentille 22, par exemple asphérique, pour guider le faisceau laser L sortant de l'ouverture 16 de la diode laser 2, en direction d'une surface de travail S. Une seconde lentille 21, par exemple asphérique, centrée sur la première lentille recouvre la matrice de pixels 10 de la région photosensible 1a de manière à rediriger la lumière réfléchie R par la surface de travail S vers les pixels de la matrice.

Comme la diode laser est disposée au centre de la matrice 10, le faisceau laser émis L et la lumière réfléchie R sur la surface de travail S parcourent un très court chemin. Grâce à cela et à la cohérence du faisceau laser généré, la diode laser peut être alimentée selon un petit rapport cyclique tout en produisant une aire illuminée réduite. Ceci permet de réduire la consommation en énergie électrique du module pour accroître la durée de vie de la cellule de batterie de la souris.

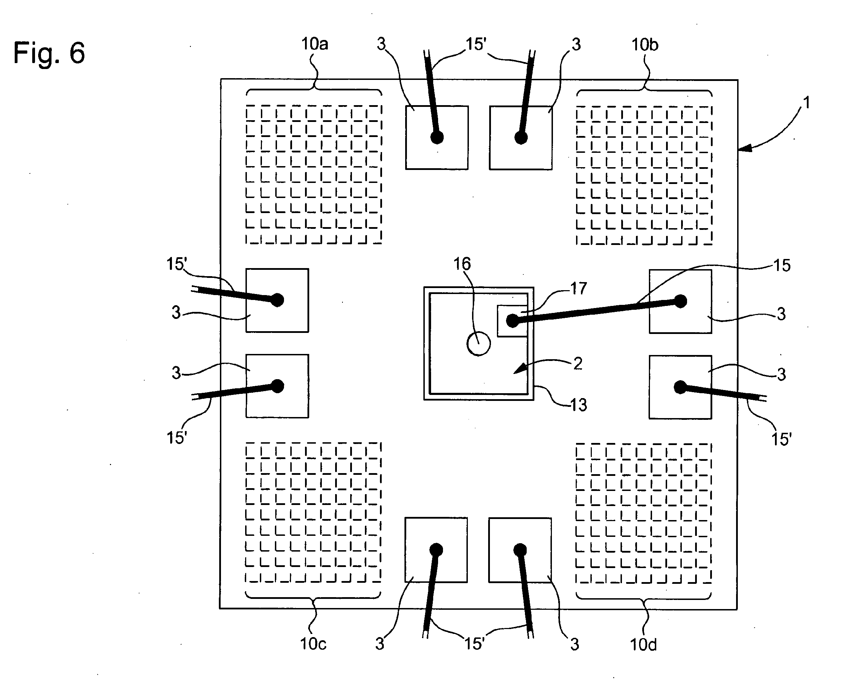

Une troisième forme d'exécution du circuit optoélectronique est représentée à la figure 6. Ce circuit optoélectronique comprend un photorécepteur 1 de forme sensiblement carrée vue de dessus, et une diode laser 2 montée au centre sur le photorécepteur 1. La diode laser VCSEL 2 est positionnée et électriquement connectée sur une plage de contact dans une cavité centrale 13 réalisée à travers la couche de passivation du photorécepteur comme expliqué ci-dessus en référence à la figure 1a.

La cavité centrale 13 est réalisée dans la même étape du procédé de fabrication du photorécepteur 1, que les ouvertures donnant accès à des plages métalliques de contact 3. Ces plages de contact 3 disposées en périphérie du photorécepteur sont susceptibles d'être reliées par un fil en aluminium 15' à des plages correspondantes d'une plaque à circuit imprimé non représentée. L'électrode 17 sur la surface supérieure de la diode laser 2 est quant à elle reliée à une des plages de contact 3 du photorécepteur au moyen d'un fil en or 15. De cette manière, la diode laser peut être alimentée par l'intermédiaire du photorécepteur pour la génération du faisceau laser sortant par l'ouverture centrale 16 dans l'électrode 17.

Le photorécepteur 1 comprend dans cette troisième forme d'exécution plusieurs régions photosensibles constituées par 4 matrices de pixels 10a, 10b, 10c, 10d de dimension équivalente. Chaque matrice, disposée dans chaque coin du photorécepteur 1, peut comprendre par exemple 16 x 16 pixels. L'agencement de ces matrices de pixels et des plages de contact 3 peut être totalement symétrique avec deux plages de contact entre deux matrices de chaque côté du photorécepteur 1. Les dimensions en largeur et longueur du photorécepteur 1 peuvent être par exemple de l'ordre de 1.8 mm sur 1.8 mm.

Ce photorécepteur 1 peut comprendre entre chaque matrice au moins une région à unité de commande et de traitement des signaux fournis par les pixels. Cependant, il peut aussi être concevable que le photorécepteur 1 ne comprend que les régions photosensibles et une portion pour recevoir la diode laser 2. Dans ce cas de figure, la diode laser doit être commandée par une unité externe par l'intermédiaire du photorécepteur 1.

Bien entendu, il peut être imaginé également que les 4 matrices de pixels sont chacune de dimension différente ou deux matrices semblables différentes des deux autres matrices semblables. La taille de pixels des matrices peut aussi être semblable ou différente d'une matrice à l'autre.

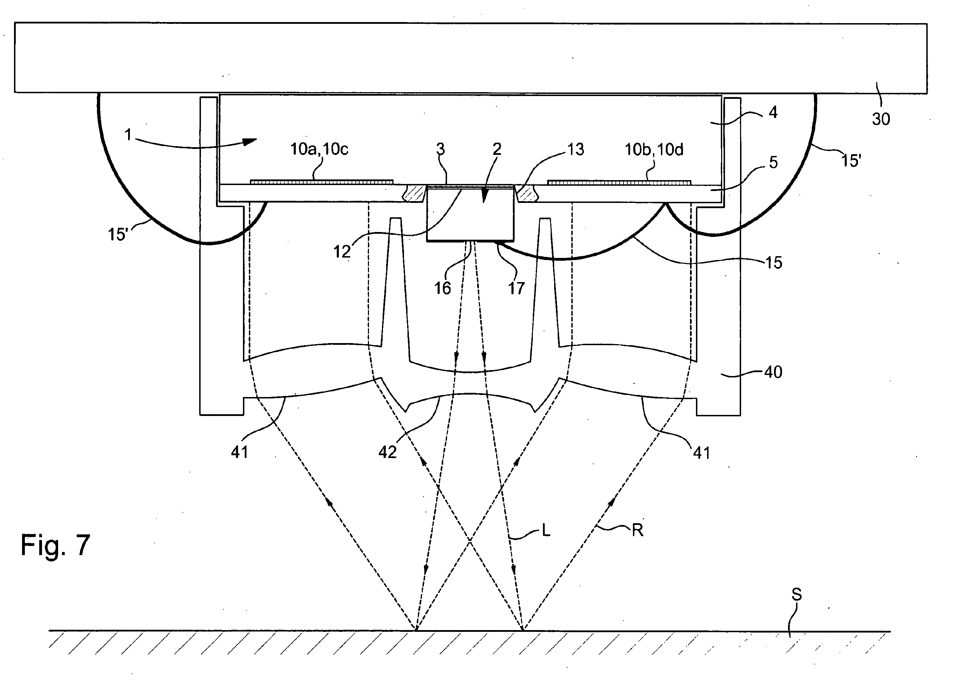

Le circuit optoélectronique de cette troisième forme d'exécution montrée à la figure 6 peut être monté dans un module optoélectronique comme représenté de manière simplifiée en coupe verticale partielle à la figure 7.

Le dos du substrat 4 du photorécepteur 1 est fixé sur une plaque ou support à circuit imprimé 30. Certaines plages de contact du photorécepteur accessibles à travers la couche de passivation 5 et disposées en périphérie du photorécepteur peuvent être reliées chacune par un fil métallique 15' en aluminium à des plages conductrices correspondantes de la plaque à circuit imprimé 30. Le photorécepteur 1 comprend encore 4 matrices de pixels 10a, 10b, 10c, 10d représentées de manière simplifiée et disposées dans chaque coin.

Une borne de masse 12 au dos de la diode laser VCSEL 2 est connectée dans la cavité centrale 13 sur une plage de contact 3 du photorécepteur prévue à cet effet. L'électrode 17 sur la surface supérieure de la diode est quant à elle reliée par un fil métallique en or 15 à une des plages de contact de commande du photorécepteur.

Le module optoélectronique comprend encore un bloc unique de lentilles 40, qui est disposé sur le photorécepteur pour le couvrir totalement. Ce bloc de lentilles 40 peut prendre appui ou être fixé sur la plaque à circuit imprimé 30 tout en laissant des ouvertures pour le passage des fils métalliques de connexion 15' du photorécepteur à la plaque à circuit imprimé. Dans le cas où au moins une région à unité de commande et de traitement est prévue dans le photorécepteur 1, cette région peut être recouverte par un cache opaque non représenté ou être revêtu d'une résine d'encapsulation conventionnelle.

Ce bloc de lentilles 40 comprend une lentille centrale 42 prévue pour diriger le faisceau laser L généré par la diode laser 2 en direction d'une surface de travail S. Le bloc de lentilles comprend encore 4 lentilles périphériques 41 disposées chacune respectivement au-dessus d'une matrice de pixels 10a, 10b, 10c, 10d de manière à rediriger la lumière réfléchie R sur la surface de travail sur les pixels de chaque matrice.

Grâce à l'agencement des éléments du circuit optoélectronique et du module le comprenant, une optimisation de la distance optique minimale est ainsi réalisée. Un spot ou faisceau laser étroit et à faible intensité peut être généré par la diode laser tout en garantissant un champ maximal pour collecter la lumière par toutes les matrices de pixels avec plusieurs champs de vue. Avec un seul bloc optique, le montage du module optoélectronique est réalisé avec des tolérances d'assemblage optimales. La distance minimale de la diode laser à la surface de travail S peut être réduite jusqu'à une distance de l'ordre de 1.8 mm par exemple.

A partir de la description qui vient d'être faite, plusieurs variantes de réalisation du circuit optoélectronique et du module le comprenant peuvent être conçues par l'homme du métier sans sortir du cadre de l'invention définie par les revendications. Il peut être envisagé de monter plusieurs diodes lasers VCSEL sur le photorécepteur, qui peuvent être monomode ou multimode. Une diode laser d'un autre type peut aussi être agencé pour un montage direct sur une portion du photorécepteur. Le photorécepteur peut comprendre plusieurs matrices de pixels de taille semblable ou différente pour détecter plusieurs catégories de mouvement. Il peut être prévu également pour le module optoélectronique un agencement de filtres optiques micro-fabriqués pour décroître la taille du photorécepteur.

## Revendications

1. Circuit optoélectronique comprenant :
- un photorécepteur (1) réalisé dans un premier matériau semi-conducteur (4), le photorécepteur comprenant au moins une région photosensible (1a) à matrice de pixels pour capter de la lumière,
- une diode laser (2) réalisée dans un second matériau semi-conducteur différent du premier matériau semi-conducteur,
**caractérisé en ce que** la diode laser est montée et électriquement connectée directement dans une cavité (13) réalisée à travers une couche de passivation (5) sur une partie du photorécepteur

2. Circuit optoélectronique selon la revendication 1, **caractérisé en ce que** la diode laser est une diode laser VCSEL monomode (2) à fourniture d'un faisceau laser (L) dans une direction sensiblement perpendiculaire à la surface du photorécepteur sur laquelle est montée ladite diode, et **en ce que** le second matériau semi-conducteur de la diode laser VCSEL est composé d'arséniure de gallium.

3. Circuit optoélectronique selon l'une des revendications précédentes, **caractérisé en ce qu'**au moins une première plage métallique de contact (3) accessible du photorécepteur (1) est disposée au fond de la cavité (13) pour une connexion électrique avec au moins une borne conductrice (12, 14) au dos de la diode laser, ledit photorécepteur comprenant également plusieurs autres plages de contact (3) accessibles depuis l'extérieur à travers des ouvertures dans la couche de passivation.

4. Circuit optoélectronique selon la revendication 3, **caractérisé en ce que** la première plage métallique de contact (3) dans la cavité (13) est composée de plusieurs portions métalliques pour faciliter la fixation de la borne conductrice de la diode dans la cavité.

5. Circuit optoélectronique selon la revendication 3, **caractérisé en ce que** la diode laser VCSEL (2) comprend une électrode (17) sur une surface supérieure au centre de laquelle est prévue une ouverture (16) de passage d'un faisceau laser (L) généré par la diode laser, et **en ce que** l'électrode est reliée par un fil métallique (15) à une seconde plage de contact (3) du photorécepteur, une tension d'alimentation pouvant être fournie entre l'électrode (17) et la borne conductrice (12) au dos de la diode par l'intermédiaire du photorécepteur pour la génération du faisceau laser.

6. Circuit optoélectronique selon la revendication 3, **caractérisé en ce que** la diode laser VCSEL (2) comprend au moins deux bornes conductrices (14) disposées au dos de la diode pour être connectées à deux plages respectives de contact accessibles à travers la cavité (13) recevant ladite diode laser.

7. Circuit optoélectronique selon l'une des revendications précédentes, **caractérisé en ce que** le photorécepteur, réalisée dans un substrat en silicium comme premier matériau, comprend au moins une région photosensible (1a), qui comprend au moins une matrice de pixels (10, 10', 10"), et une région adjacente à unité de commande et de traitement (1b) des signaux fournis par les pixels de la matrice.

8. Circuit optoélectronique selon l'une des revendications précédentes, **caractérisé en ce que** la diode laser (2) est positionnée et électriquement connectée au centre de la matrice de pixels (10, 10', 10").

9. Circuit optoélectronique selon la revendication 7, **caractérisé en ce que** la diode laser (2) est montée et électriquement connectée dans la région (1b) à unité de commande et de traitement des signaux.

10. Circuit optoélectronique selon l'une des revendications 1 à 7, **caractérisé en ce que** la région photosensible (1a) du photorécepteur (1) comprend une première matrice de pixels (10") disposée au centre d'une seconde matrice de pixels (10'), et **en ce que** la première matrice de pixels est composée de pixels plus fins, que la seconde matrice de pixels.

11. Circuit optoélectronique selon la revendication 1, **caractérisé en ce que** le photorécepteur (1) comprend plusieurs matrices de pixels, notamment 4 matrices de pixels (10a, 10b, 10c, 10d), et **en ce que** la diode laser (2) est montée et électriquement connectée au centre du photorécepteur.

12. Circuit optoélectronique selon la revendication 11, **caractérisé en ce que** les 4 matrices de pixels sont de dimension équivalente et disposées dans chaque coin du photorécepteur, et **en ce que** des plages de contact (3) du photorécepteur accessibles par des ouvertures à travers une couche de passivation (5) du photorécepteur sont disposées régulièrement en périphérie du photorécepteur et entre chaque matrice de pixels.

13. Circuit optoélectronique selon la revendication 7, **caractérisé en ce que** toutes les plages de contact (3) du photorécepteur accessibles par des ouvertures à travers une couche de passivation (5) du photorécepteur, sont agencées uniquement du côté de la région à unité de commande et de traitement (1b), qui est juxtaposée à la région photosensible (1a).

14. Circuit optoélectronique selon la revendication 13, **caractérisé en ce que** la diode laser (2) est montée et électriquement connectée dans une cavité (13) réalisée à travers une couche de passivation (5) dans la région à unité de commande et de traitement (1 b) du photorécepteur à proximité de la région photosensible (1a), la dimension de la cavité étant sensiblement équivalente à la dimension de la diode de manière à la guider et positionner sur une première plage de contact (3) métallique du photorécepteur au fond de la cavité, et **en ce qu'**une électrode sur la surface supérieure de la diode est reliée par un fil métallique à une seconde plage de contact (3) adjacente du photorécepteur.

15. Module optoélectronique comprenant un circuit optoélectronique selon l'une des revendications précédentes, ledit circuit optoélectronique étant monté sur une plaque ou support à circuit imprimé (30), **caractérisé en ce qu'**il comprend un unique bloc de lentilles (20, 40) disposé au moins sur la région photosensible (1a) du photorécepteur (1), l'unique bloc de lentilles permettant un partage de l'optique entre la diode laser (2) et au moins une matrice de pixels (10, 10', 10").

16. Module optoélectronique selon la revendication 15, **caractérisé en ce que** la diode laser (2) est montée au centre d'au moins une matrice de pixels (10, 10', 10") de la région photosensible, et **en ce qu'**une première lentille (22) du bloc de lentilles est dans une position centrale au-dessus de la diode laser (2) pour guider le faisceau laser (L) sortant d'une ouverture centrale (16) sur le dessus de la diode laser, en direction d'une surface de travail (S), et **en ce qu'**une seconde lentille (21) est centrée sur la première lentille (22) afin de recouvrir la matrice de pixels (10, 10', 10") de la région photosensible (1a) pour rediriger la lumière réfléchie (R) par la surface de travail (S) vers les pixels de la matrice.

## Claims

1. Optoelectronic circuit including:
- a photoreceptor (1) made in a first semiconductor material (4), the photoreceptor including at least one photosensitive area (1a) with a pixel array for picking up light,
- a laser diode (2) made in a second semiconductor material different from the first semiconductor material,
**characterized in that** the laser diode is mounted and electrically connected directly in a cavity (13) made through a passivation layer (5) on one part of the photoreceptor.

2. Optoelectronic circuit according to claim 1, **characterized in that** the laser diode is a monomode VCSEL laser diode (2) supplying a laser beam (L) in a substantially perpendicular direction to the surface of the photoreceptor on which said diode is mounted, and **in that** the second semiconductor material of the VCSEL laser diode is formed of gallium arsenide.

3. Optoelectronic circuit according to any one of the preceding claims, **characterized in that** at least one accessible first metal contact pad (3) of the photoreceptor (1) is arranged at the bottom of the cavity (13) for electrical connection to at least one conductive terminal (12, 14) on the back of the laser diode, said photoreceptor also including several other contact pads (3) accessible from the exterior through apertures in the passivation layer.

4. Optoelectronic circuit according to claim 3, **characterized in that** the first metal contact pad (3) in the cavity (13) is formed of several metal portions to facilitate the securing of the conductive terminal of the diode in the cavity.

5. Optoelectronic circuit according to claim 3, **characterized in that** the VCSEL laser diode (2) includes an electrode (17) on a top surface at the centre of which there is provided an aperture (16) for the passage of a laser beam (L) generated by the laser diode, and **in that** the electrode is connected by a metal wire (15) to a second contact pad (3) of the photoreceptor, a supply voltage being able to be provided between the electrode (17) and the conductive terminal (12) at the back of the diode via the photoreceptor in order to generate the laser beam.

6. Optoelectronic circuit according to claim 3, **characterized in that** the VCSEL laser diode (2) includes at least two conductive terminals (14) arranged on the back of the diode to be connected to two respective contact pads accessible through the cavity (13) receiving said laser diode.

7. Optoelectronic circuit according to any one of the preceding claims, **characterized in that** the photoreceptor, made in a silicon substrate like the first material, includes at least one photosensitive area (1a), which includes at least one pixel array (10, 10', 10"), and an adjacent area with a control and processing unit (1b) for the signals supplied by the pixels of the array.

8. Optoelectronic circuit according to any one of the preceding claims, **characterized in that** the laser diode (2) is positioned and electrically connected at the centre of the pixel array (10, 10', 10").

9. Optoelectronic circuit according to claim 7, **characterized in that** the laser diode (2) is mounted and electrically connected in the signal control and processing unit area (1 b).

10. Optoelectronic circuit according to any one of claims 1 to 7, **characterized in that** the photosensitive area (1 a) of the photoreceptor (1) includes a first pixel array (10") arranged at the centre of a second pixel array (10'), and **in that** the first pixel array is formed of finer pixels than the second pixel array.

11. Optoelectronic circuit according to claim 1, **characterized in that** the photoreceptor (1) includes several pixel arrays, in particular 4 pixel arrays (10a, 10b, 10c, 10d), and **in that** the laser diode (2) is mounted and electrically connected at the centre of the photoreceptor.

12. Optoelectronic circuit according to claim 11, **characterized in that** the 4 pixel arrays are of the same dimensions and are arranged in each corner of the photoreceptor, and **in that** contact pads (3) of the photoreceptor accessible through apertures through a passivation layer (5) of the photoreceptor are arranged regularly at the periphery of the photoreceptor and between each pixel array.

13. Optoelectronic circuit according to claim 7, **characterized in that** all of contact pads (3) of the photoreceptor that are accessible through apertures through a passivation layer (5) of the photoreceptor, are arranged solely on the side of the control and processing unit area (1b), which is juxtaposed with the photosensitive area (1a).

14. Optoelectronic circuit according to claim 13, **characterized in that** the laser diode (2) is mounted and electrically connected in a cavity (13) made through a passivation layer (5) in the control and processing unit area (1 b) of the photoreceptor in proximity to the photosensitive area (1 a), the dimensions of the cavity being substantially equal to the dimensions of the diode so as to guide and position said diode onto a first metal contact pad (3) of the photoreceptor at the bottom of the cavity, and **in that** an electrode on the top surface of the diode is connected by a metal wire to a second adjacent contact pad (3) of the photoreceptor.

15. Optoelectronic module comprising an optoelectronic circuit according to any one of the preceding claims, said optoelectronic circuit being mounted on a printed circuit board or support (30), **characterized in that** it includes a single lens unit (20, 40) arranged at least on the photosensitive area (1a) of the photoreceptor (1), the single lens unit allowing optical splitting between the laser diode (2) and at least one pixel array (10, 10', 10").

16. Optoelectronic module according to claim 15, **characterized in that** the laser diode (2) is mounted at the centre of at least one pixel array (10, 10', 10") of the photosensitive area, and **in that** a first lens (22) of the lens unit is in a central position above the laser diode (22) in order to guide the laser beam (L) exiting a central aperture (16) on the top of the laser diode, in the direction of a work surface (S), and **in that** a second lens (21) is centred on the first lens (22) in order to cover the pixel array (10, 10', 10") of the photosensitive area (1a) to redirect the light (R) reflected by the work surface (S) towards the pixels of the array.

## Patentansprüche

1. Optoelektronische Schaltung, die umfasst:
- einen Photoempfänger (1), der aus einem ersten Halbleitermaterial (4) hergestellt ist, wobei der Photoempfänger wenigstens einen lichtempfindlichen Bereich (1a) mit einer Pixelmatrix aufweist, um Licht einzufangen,
- eine Laserdiode (2), die aus einem zweiten Halbleitermaterial hergestellt ist, das von dem ersten Halbleitermaterial verschieden ist,
**dadurch gekennzeichnet, dass** die Laserdiode in einer Vertiefung (13), die durch eine Passivierungsschicht (5) auf einem Teil des Photoempfängers ausgebildet ist, montiert ist und darin direkt elektrisch angeschlossen ist.

2. Optoelektronische Schaltung nach Anspruch 1, **dadurch gekennzeichnet, dass** die Laserdiode eine Monomoden-VCSEL-Laserdiode (2) ist, die ein Laserstrahlenbündel (L) in einer Richtung liefert, die zu der Oberfläche des Photoempfängers, auf der die Diode montiert ist, im Wesentlichen senkrecht ist, und dass das zweite Halbleitermaterial der VCSEL-Laserdiode aus Galliumarsenid gebildet ist.

3. Optoelektronische Schaltung nach einem der vorhergehenden Ansprüche, **dadurch gekennzeichnet, dass** wenigstens ein erster vom Photoempfänger (1) zugänglicher metallischer Kontaktbereich (3) auf dem Boden der Vertiefung (13) für eine elektrische Verbindung mit wenigstens einem leitenden Anschluss (12, 14) auf der Rückseite der Laserdiode angeordnet ist, wobei der Photoempfänger außerdem mehrere weitere Kontaktbereiche (3) aufweist, die von außerhalb durch Öffnungen in der Passivierungsschicht zugänglich sind.

4. Optoelektronische Schaltung nach Anspruch 3, **dadurch gekennzeichnet, dass** der erste metallische Kontaktbereich (3) in der Vertiefung (13) aus mehreren metallischen Abschnitten gebildet ist, um die Befestigung des leitenden Anschlusses der Diode in der Vertiefung zu erleichtern.

5. Optoelektronische Schaltung nach Anspruch 3, **dadurch gekennzeichnet, dass** die VCSEL-Laserdiode (2) eine Elektrode (17) auf einer oberen Oberfläche aufweist, in deren Zentrum eine Öffnung (16) für den Durchgang eines von der Laserdiode erzeugten Laserstrahlenbündels (L) vorgesehen ist, und dass die Elektrode über einen Metalldraht (15) mit einem zweiten Kontaktbereich (3) des Photoempfängers verbunden ist, wobei über den Photoempfänger zwischen der Elektrode (17) und dem leitenden Anschluss (12) auf der Rückseite der Diode eine Versorgungsspannung angelegt werden kann, um das Laserstrahlenbündel zu erzeugen.

6. Optoelektronische Schaltung nach Anspruch 3, **dadurch gekennzeichnet, dass** die VCSEL-Laserdiode (2) wenigstens zwei leitende Anschlüsse (14) umfasst, die auf der Rückseite der Diode angeordnet sind, um mit zwei entsprechenden Kontaktbereichen verbunden zu werden, die durch die die Laserdiode aufnehmende Vertiefung (13) zugänglich sind.

7. Optoelektronische Schaltung nach einem der vorhergehenden Ansprüche, **dadurch gekennzeichnet, dass** der Photoempfänger, der in einem Siliciumsubstrat als erstes Material hergestellt ist, wenigstens einen lichtempfindlichen Bereich (1a), der wenigstens eine Pixelmatrix (10, 10', 10") umfasst, und einen Bereich (1 b), der zu der Steuer- und Verarbeitungseinheit für die von der Pixelmatrix gelieferten Signale benachbart ist, umfasst.

8. Optoelektronische Schaltung nach einem der vorhergehenden Ansprüche, **dadurch gekennzeichnet, dass** die Laserdiode (2) im Zentrum der Pixelmatrix (10,10', 10") positioniert und elektrisch angeschlossen ist.

9. Optoelektronische Schaltung nach Anspruch 7, **dadurch gekennzeichnet, dass** die Laserdiode (2) in dem Bereich (1b) mit der Einheit für die Steuerung und Verarbeitung der Signale montiert und elektrisch angeschlossen ist.

10. Optoelektronische Schaltung nach einem der Ansprüche 1 bis 7, **dadurch gekennzeichnet, dass** der lichtempfindliche Bereich (1 a) des Photoempfängers (1) eine erste Pixelmatrix (10"), die in der Mitte einer zweiten Pixelmatrix (10') angeordnet ist, umfasst und dass die erste Pixelmatrix aus feineren Pixeln als die zweite Pixelmatrix gebildet ist.

11. Optoelektronische Schaltung nach Anspruch 1, **dadurch gekennzeichnet, dass** der Photoempfänger (1) mehrere Pixelmatrizen, insbesondere 4 Pixelmatrizen (10a, 10b, 10c, 10d) umfasst und dass die Laserdiode (2) in der Mitte des Photoempfängers montiert und elektrisch angeschlossen ist.

12. Optoelektronische Schaltung nach Anspruch 11, **dadurch gekennzeichnet, dass** die 4 Pixelmatrizen äquivalente Abmessungen haben und in jeder Ecke des Photoempfängers angeordnet sind und dass die Kontaktbereiche (3) des Photoempfängers, die durch die Öffnungen durch eine Passivierungsschicht (5) des Photoempfängers zugänglich sind, am Umfang des Photoempfängers und zwischen jeder Pixelmatrix regelmäßig angeordnet sind.

13. Optoelektronische Schaltung nach Anspruch 7, **dadurch gekennzeichnet, dass** alle Kontaktbereiche (3) des Photoempfängers, die durch Öffnungen durch eine Passivierungsschicht (5) des Photoempfängers zugänglich sind, ausschließlich auf Seiten des Bereichs (1 b) mit der Steuer- und Verarbeitungseinheit, der neben dem lichtempfindlichen Bereich (1a) liegt, angeordnet sind.

14. Optoelektronische Schaltung nach Anspruch 13, **dadurch gekennzeichnet, dass** die Laserdiode (2) in einer Vertiefung (13), die durch eine Passivierungsschicht (5) in dem Bereich (1b) mit der Steuer- und Verarbeitungseinheit des Photoempfängers in der Nähe des lichtempfindlichen Bereichs (1a) hergestellt ist, montiert und elektrisch angeschlossen ist, wobei die Abmessung der Vertiefung zu der Abmessung der Diode im Wesentlichen äquivalent ist, derart, dass sie in einem ersten metallischen Kontaktbereich (3) des Photoempfängers auf dem Boden der Vertiefung geführt und positioniert wird, und dass eine Elektrode auf der oberen Oberfläche der Diode über einen Metalldraht mit einem zweiten Kontaktbereich (3) benachbart zu dem Photoempfänger verbunden ist.

15. Optoelektronisches Modul, das eine optoelektronische Schaltung nach einem der vorhergehenden Ansprüche umfasst, wobei die optoelektronische Schaltung auf einer Platte oder einem Träger mit gedruckter Schaltung (30) montiert ist, **dadurch gekennzeichnet, dass** es einen einzigen Linsenblock (20, 40) umfasst, der wenigstens auf dem lichtempfindlichen Bereich (1a) des Photoempfängers (1) angeordnet ist, wobei der einzige Linsenblock eine gemeinsame Nutzung der Optik zwischen der Laserdiode (2) und wenigstens einer Pixelmatrix (10, 10', 10") ermöglicht.

16. Optoelektronisches Modul nach Anspruch 15, **dadurch gekennzeichnet, dass** die Laserdiode (2) in der Mitte wenigstens einer Pixelmatrix (10, 10', 10") des lichtempfindlichen Bereichs montiert ist und dass sich eine erste Linse (22) des Linsenblocks an einer Mittelposition über der Laserdiode (2) befindet, um das Laserstrahlenbündel (L), das aus einer mittigen Öffnung (16) oben auf der Laserdiode austritt, in Richtung einer Arbeitsoberfläche (S) zu führen, und dass eine zweite Linse (21) auf der ersten Linse (22) zentriert ist, um die Pixelmatrix (10, 10', 10") des lichtempfindlichen Bereichs (1a) abzudecken, um das durch die Arbeitsoberfläche (S) reflektierte Licht (R) zu den Pixeln der Matrix umzulenken.
